# DEMANDE DE BREVET EUROPEEN

(11) **EP 2 708 923 A1**
(43) Date de publication de la demande: **19.03.2014**
(21) Numéro de dépôt: 13195794.6
(22) Date de dépôt: 14.09.2010
(51) Int. Cl.: G02B 3/14, G02B 26/08

(54) **Dispositif optique à membrane déformable à actionnement piézoélectrique en forme de couronne continue**

(30) Priorité: 15.09.2009 FR 0956328
(62) Demande divisionnaire de: 10755131.9
(71) Demandeur: Commissariat à l'Énergie Atomique et aux Énergies Alternatives, 75015 Paris (FR)
(72) Inventeur: Moreau, Stéphane, 38340 Le Chevalon de Voreppe (FR); Bolis, Sébastien, 38920 Crolles (FR)
(74) Mandataire: Ahner, Philippe

(57) **Abrégé**

Dispositif optique à membrane (2) déformable comportant une zone d'ancrage (2.3) sur un support (1) emprisonnant du fluide liquide ou gazeux, une zone centrale (2.1) apte à se déformer de manière réversible depuis une position de repos, des moyens d'actionnement pour déplacer le fluide (4) sollicitant la membrane (2) dans une zone intermédiaire entre zone d'ancrage (2.3) et zone centrale (2.1). Les moyens d'actionnement comportent une couronne continue piézoélectrique accueillant plusieurs actionneurs, cette couronne entourant la zone centrale (2.1), les moyens d'actionnement (5) étant ancrés à la membrane (2) dans au moins la zone intermédiaire (2.2), les moyens d'actionnement (5) et la membrane (2) à laquelle ils sont ancrés formant au moins un bimorphe piézoélectrique (B), les moyens d'actionnement (5) se contractant ou s'étendant radialement lors d'un actionnement de manière à engendrer un déplacement dudit fluide (4) depuis la zone intermédiaire (2.2) vers la zone centrale (2.1) de la membrane (2) ou vice versa visant à déformer la zone centrale (2.1) par rapport à sa position de repos.

## Description

### DOMAINE TECHNIQUE

La présente invention concerne un dispositif optique à membrane déformable piégeant du fluide et doté de moyens d'actionnement de la membrane de type piézoélectriques pour ajuster le rayon de courbure de la membrane dans sa partie centrale. Un tel dispositif optique à membrane déformable peut être une lentille liquide à focale variable, une lentille liquide à correction d'aberrations optiques, pour de l'optique adaptative, ou un miroir à focale variable.

Les lentilles liquides sont utilisables par exemple dans les téléphones portables avec fonction d'appareil photographique ou de caméra. De nombreux développements sont en cours dont notamment la fonction d'autofocus et la fonction zoom. On cherche, lors de l'introduction de ces fonctions, à obtenir un temps de réponse le plus court possible mais aussi à diminuer la consommation d'énergie lors de l'actionnement et à augmenter les variations de la focale à consommation d'énergie donnée, tout en évitant de rendre complexe la fabrication de tels appareils. Plus globalement, on cherche à intégrer le plus possible les constituants des ces appareils photos miniatures pour réduire les coûts, l'encombrement et la consommation d'énergie. Ces appareils photos miniatures, fonctionnant dans le visible, sont connus sous la dénomination anglo-saxonne CCM pour « compact camera module ». La technologie de lentille liquide la plus aboutie pour cette application est pour l'instant celle basée sur le principe de l'électro-mouillage.

Une autre application concerne les caméras fonctionnant dans l'infrarouge (IR). L'avancement en termes d'intégration est moindre, dans la plupart des cas, les optiques sont dissociées des caméras. Plusieurs développements sont en cours dont notamment l'intégration des optiques (création d'un module caméra), l'intégration de la fonction autofocus,... Pour l'instant, les solutions techniques associées ne sont pas connues et demandent à être définies.

Dans une application de miroir à membrane déformable, cette dernière est réfléchissante. On peut être amené à vouloir ajuster la distance focale du miroir et donc son rayon de courbure. Un tel miroir peut être utilisé en ophtalmologie ou en optique adaptative. Enfin, ces dispositifs optiques, qu'ils soient de type lentille ou miroir peuvent être utilisés pour stabiliser des images.

### ÉTAT DE LA TECHNIQUE ANTÉRIEURE

La demande de brevet FR 2 919 073 décrit un dispositif optique comportant une membrane souple ayant une zone périphérique d'ancrage sur un support, la membrane et le support emprisonnant un volume donné de fluide et des moyens d'actionnement piézoélectriques pour déplacer le fluide au niveau de la zone centrale de la membrane, afin de déformer la zone centrale de la membrane. Le volume est sensiblement constant dans une plage de températures donnée. Les moyens d'actionnement sont formés d'une pluralité de micro-poutres radiales, qui sont fixées à une extrémité sur le support et dont l'autre extrémité agit sur la membrane dans une zone située entre la zone centrale et la zone d'ancrage. Un inconvénient de cette configuration est qu'elle est encombrante puisque les moyens d'actionnement prennent appui sur le support. Un autre inconvénient est que pour un encombrement donné, et une consommation énergétique donnée, lors de l'actionnement, les performances optiques du dispositif ne sont pas optimales. De manière similaire, pour un encombrement donné, et des performances optiques données, la consommation énergétique est importante lors de l'actionnement.

D'autres demandes de brevet décrivent des dispositifs optiques à moyens d'actionnement piézoélectriques. On peut citer le brevet US 4 802 746 dans lequel un élément cylindrique en matériau piézoélectriques, est fermé à ses deux extrémités par des parois en matériau élastique, l'ensemble définissant une cavité contenant un matériau solide élastique.

Dans le brevet américain US 4 407 567, une lentille à distance focale variable comporte une cavité communiquant avec une chambre d'expansion, la cavité étant délimitée par une paroi mobile ancrée sur un support.

Dans la demande de brevet internationale WO 2008/076399 est décrite une lentille à distance focale variable dans lequel des moyens d'actionnement en polymère conducteur ionique ou, en variante, en matériau piézoélectrique sont rapportés sur la membrane sans en être solidaires directement et transmettent une force d'actionnement sensiblement selon l'axe optique du dispositif. Les moyens d'actionnement prennent la forme d'une couronne continue dotée d'une pluralité de doigts radiaux, rapportée à proximité de la membrane.

La demande de brevet US 2002/0048096 montre une lentille ou un miroir déformables grâce à l'action d'éléments piézoélectriques en barreaux agencés radialement. Il n'y a pas de fluide emprisonné sous la plaque sur laquelle les éléments piézoélectriques sont ancrés.

La demande de brevet W02008/100154 montre un dispositif optique comportant une cavité contenant un matériau de type gel ou élastomère fermée par des couvercles transparents. Des moyens d'actionnement de type piézoélectriques coopèrent avec l'un des couvercles qui est en verre. La rigidité de ce couvercle est un frein à l'efficacité de l'actionnement et le matériau contenu dans la cavité, puisqu'il est type gel ou élastomère, n'apporte pas la contre réaction espérée sous l'effet de l'actionnement pour déformer la zone centrale des couvercles. C'est le centre de la membrane qui déforme le gel ou l'élastomère sous l'effet de l'actionnement et cette membrane requiert une rigidité importante pour obtenir une déformation donnée. Un tel dispositif optique est peu performant.

### EXPOSÉ DE L'INVENTION

La présente invention a justement pour but de fournir un dispositif optique à membrane déformable tel une lentille ou un miroir qui ne possède pas les inconvénients mentionnés ci-dessus à savoir l'encombrement, la consommation énergétique importante, le manque d'efficacité de l'actionnement.

Un autre but de l'invention est de fournir un dispositif optique à membrane déformable dont la déformée de la membrane peut être ajustée de manière voulue et très finement, que la déformation soit symétrique ou non, par rapport à un axe optique du dispositif optique.

Un autre but de l'invention est de fournir un dispositif optique à membrane déformable dans lequel les aberrations optiques sont réduites.

Un autre but de l'invention est de fournir un dispositif optique à membrane déformable dans lequel les contraintes résiduelles apparaissant lors de la fabrication sont plus faciles à gérer lors de l'utilisation.

Encore un but de l'invention est de fournir un dispositif optique à membrane déformable, à compensation active en fonction de la température, de manière à conserver une distance focale inchangée même si la température ambiante varie.

Pour y parvenir, la présente invention propose un dispositif optique à membrane déformable comportant une zone d'ancrage sur un support contribuant à emprisonner une quantité de fluide liquide ou gazeux, une zone centrale apte à se déformer de manière réversible depuis une position de repos, des moyens d'actionnement pour déplacer le fluide, sollicitant la membrane dans une zone intermédiaire entre la zone d'ancrage et la zone centrale. Les moyens d'actionnement comportent une couronne continue en matériau piézoélectrique accueillant plusieurs actionneurs piézoélectriques formés chacun d'une paire d'électrodes prenant en sandwich la couronne continue, cette couronne continue étant montée autour de la zone centrale sans empiéter sur elle, les moyens d'actionnement étant ancrés à la membrane au moins dans la zone intermédiaire, les moyens d'actionnement et la membrane à laquelle ils sont ancrés formant au moins un bimorphe piézoélectrique, les moyens d'actionnement se contractant ou s'étendant radialement lors d'un actionnement de manière à engendrer un déplacement dudit fluide depuis la zone intermédiaire vers la zone centrale de la membrane ou vice versa, visant à déformer la zone centrale par rapport à sa position de repos. Cela donne beaucoup de souplesse pour obtenir une déformée voulue de la zone centrale.

Les moyens d'actionnement comportant plusieurs actionneurs piézoélectriques, ils possèdent plusieurs paires d'électrodes prenant en sandwich la couronne continue, au moins une électrode d'une paire peut être commune à deux actionneurs piézoélectriques ou plus de deux.

Cela permet de limiter le nombre de sorties électriques et de faciliter l'intégration ce qui conduit à un dispositif compact.

Les moyens d'actionnement peuvent aussi être ancrés sur la zone d'ancrage de la membrane et éventuellement sur le support directement. Selon l'ancrage ou non des moyens d'actionnement au support la déformée de la membrane est différente. Selon la forme recherchée, il peut être avantageux d'ancrer ou non les moyens d'actionnement au support.

Les moyens d'actionnement peuvent être sus-jacents à la membrane et/ou sous-jacents à la membrane et/ou intégrés dans la membrane. Ici aussi un grand nombre de possibilités est offert.

La membrane peut comporter un empilement de couches, au moins au niveau de la zone intermédiaire, parmi lesquelles une couche de renfort plus rigide et une couche moins rigide, la couche plus rigide faisant partie du bimorphe piézoélectrique. Ainsi, on peut obtenir la souplesse requise dans la zone centrale et la rigidité requise dans la zone intermédiaire.

Pour éviter des fuites de fluide, il est préférable que la membrane comporte couche continue qui s'étend au niveau de la zone centrale, de la zone intermédiaire et de la zone d'ancrage.

On peut prévoir en outre des moyens d'actionnement auxiliaires ancrés à la membrane, comportant une couronne discontinue en matériau piézoélectrique, accueillant un ou plusieurs actionneurs piézoélectriques, la couronne discontinue étant montée concentriquement avec la couronne continue, les moyens d'actionnement auxiliaires et la membrane à laquelle ils sont ancrés formant au moins un bimorphe piézoélectrique. Il est ainsi facile d'obtenir une déformée voulue de la membrane dans la zone centrale.

Il est également possible de prévoir des moyens de compensation d'une variation de la distance focale du dispositif optique en fonction de la température. Cela permet au dispositif optique de fonctionner sans réglage particulier dans une plage de températures comprise entre environ -20°C et +60°C.

Les moyens de compensation peuvent être sont confondus avec le ou les actionneurs piézoélectriques d'une couronne continue.

Les moyens de compensation peuvent comporter un ou plusieurs éléments bimorphes thermiques agencés en couronne continue, soit ancrés à la membrane au niveau de la zone d'ancrage en débordant sur la zone intermédiaire, soit fixés au support à l'opposé de la membrane par rapport audit fluide.

Les actionneurs piézoélectriques sont actionnables séparément les uns des autres ou bien tous ensemble simultanément ou bien encore ils sont actionnables simultanément par groupes. Cela donne une grande souplesse pour obtenir une déformée voulue de la membrane dans la zone centrale.

On peut prévoir, en outre, un ou plusieurs actionneurs piézoélectriques agencés sur une couronne piézoélectrique, ancrés à la membrane dans la zone intermédiaire et éventuellement dans la zone d'ancrage, aptes à fonctionner passivement par effet piézoélectrique direct et dédiés à une surveillance d'une déformation de la membrane.

Le dispositif optique peut comporter, en outre, un capot de protection fixé sur le support. Le capot peut être muni d'une ouverture au niveau de la zone centrale ou être étanche et emprisonner un autre fluide.

La membrane peut être réalisée à base de matériaux organiques choisis parmi le polydiméthylsiloxane, le polyméthacrylate de méthyle, le polyéthylène téréphtalate, le polycarbonate, le parylène, les résines époxydes, les polymères photosensibles, les silicones, à base de matériaux minéraux choisis parmi le silicium, l'oxyde de silicium, le nitrure de silicium, le carbure de silicium, le silicium polycristallin, le nitrure de titane, le carbone diamant, l'oxyde d'étain et d'indium, l'aluminium, le cuivre, le nickel, à base de matériau piézoélectrique.

Chacun des fluides est un liquide choisi parmi le carbonate de propylène, l'eau, un liquide d'indice, une huile optique ou encore un liquide ionique, ou un gaz choisi parmi l'air, l'azote, l'hélium.

Le matériau piézoélectrique peut être à base de PZT, de nitrure d'aluminium, de polyfluorure de vinylidène ou de ses copolymères de trifluoroéthylène, d'oxyde de zinc, de titanate de barium, de niobate de plomb, de sillénites tels que le titanate de bismuth.

Le dispositif optique peut être une lentille ou un miroir.

La présente invention concerne également un dispositif de prise de vue qui comporte au moins un dispositif optique ainsi caractérisé.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
les figures 1A à 1C montrent en coupe en vue de dessus un dispositif optique utile pour la compréhension de l'invention, la membrane du dispositif optique de la figure 1A étant plus souple que celle du dispositif optique de la figure 1C, la figure 1D montrant également en vue de dessus un autre dispositif optique utile pour la compréhension de l'invention à actionneur piézoélectrique unique ;
les figures 2A, 2B permettent de comprendre le fonctionnement d'un élément piézoélectrique muni d'une paire d'électrodes ;
les figures 3A à 3G sont des vues de dessus de différentes variantes du dispositif optique selon l'invention ;
les figures 4A à 4C montrent en coupe l'ancrage de la membrane, pour différents types de membrane ;
les figures 5A à 5M montrent en coupe différents agencements entre la membrane et les moyens d'actionnement ;
les figures 6A à 6E montrent différentes configurations du support sur lequel est ancrée la membrane d'un dispositif optique selon l'invention ;
les figures 7A, 7B montrent un dispositif optique selon l'invention équipé de moyens de compensation d'une variation de sa distance focale due à une variation de température ;
les figures 8A à 8G montrent différentes étapes de fabrication d'un dispositif optique selon l'invention ;
les figures 9A, 9B montrent un dispositif optique selon l'invention monté dans un dispositif de prise de vue ;
les figures 10A, 10B, 10C permettent de comparer l'efficacité entre un dispositif optique selon l'invention et un dispositif optique tel que celui décrit dans la demande de brevet FR 2 919 073.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

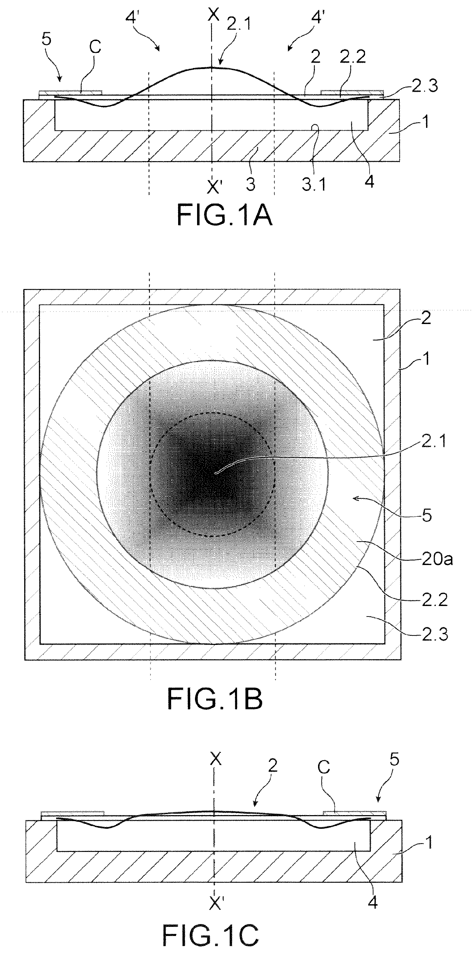

On a représenté sur les figures 1A, 1B un premier mode de réalisation d'un dispositif optique utile pour la compréhension de l'invention. La figure 1C montre un même mode de réalisation du dispositif optique mais avec une membrane plus rigide. Ce dispositif optique est construit autour d'un axe dit axe optique XX'. Il comporte une membrane 2 dont la périphérie est ancrée de manière étanche sur un support 1 qui dans cet exemple est en forme de cuvette. La membrane 2 comporte donc une zone d'ancrage référencée 2.3 qui est superposée au support 1. La membrane 2 comporte également une zone centrale 2.1 qui correspond à un champ optique du dispositif optique. Elle est matérialisée par des pointillés. La cuvette est destinée à accueillir un fluide liquide ou gazeux dit premier fluide 4. Plus généralement la membrane 2 et le support 1 contribuent à former une cavité 3 dans laquelle est emprisonné le fluide 4.

Une des faces de la membrane 2 est en contact avec le fluide 4 contenu dans la cavité 3. L'autre face de la membrane 2 est en contact avec un second fluide 4' qui peut être l'air ambiant. On verra plus loin une variante dans laquelle le second fluide 4' est piégé, il peut s'agir d'air ou d'un autre gaz ou même d'un liquide.

Par membrane 2, on entend tout film souple faisant office de barrière entre le premier fluide 4 et le second fluide 4' se trouvant de l'autre côté de la barrière par rapport au premier fluide 4.

Dans le cas où le dispositif optique est une lentille, la cavité 3 a un fond 3.1 qui est transparent à un faisceau optique (non représenté) destiné à se propager à travers la lentille. De plus, la membrane 2 est transparente au faisceau optique au moins dans la zone centrale 2.1. Si le dispositif optique est un miroir, la membrane 2 est réfléchissante au moins dans sa zone centrale 2.1. Le faisceau optique peut être un faisceau visible, mais il peut s'étendre au-delà du visible dans l'infra rouge par exemple.

La membrane 2 est souple et apte à se déformer de manière réversible, depuis une position de repos représentée sur la figure 1A, sous l'action d'un déplacement du fluide 4 contenu dans la cavité 3 de manière à faire varier l'épaisseur de fluide 4 se trouvant au niveau de la zone centrale 2.1 de la membrane 2 et ainsi courber la zone centrale 2.1 de la membrane 2. Le fluide 4 contenu dans la cavité 3 est suffisamment incompressible pour se déplacer, vers la zone centrale 2.1 lorsque l'on applique un effort sur la membrane 2, cet effort étant appliqué sur la membrane 2 dans une zone intermédiaire 2.2 située entre la zone centrale 2.1 et la zone d'ancrage 2.3. Il a un volume sensiblement constant dans une plage de températures donnée. Le fluide 4 contenu dans la cavité sert de « transmission » entre les moyens d'actionnement 5 et la zone centrale 2.1 de la membrane 2. Ce fluide 4 peut être un liquide ou un gaz. On se sert de la contre-réaction du fluide pour lors de l'actionnement obtenir la déformation de la membrane dans la zone centrale 2.1.

On notera que sur les figures 1A, 1B le contour de la membrane 2 et le support 1 ont été représentés en carrés alors que la zone centrale 2.1 a été représentée circulaire. Bien entendu, ces formes ne sont pas limitatives. La membrane 2 et le support 1 pourraient être circulaires, rectangulaires, ovoïdes ou autre et la zone centrale 2.1 pourrait être carrée, rectangulaire ovoïde ou autre.

On prévoit des moyens d'actionnement 5 piézoélectriques, pour déplacer le fluide 4 de la cavité 3. Ils sollicitent la membrane 2 dans la zone intermédiaire 2.2. Ces moyens d'actionnement 5 sont configurés en au moins une couronne continue C circulaire en matériau piézoélectrique montée concentriquement autour de la zone centrale 2.1. Cette couronne continue C en matériau piézoélectrique accueille un actionneur piézoélectrique (non clairement visible sur les figures 1A à 1C). Chaque couronne continue C s'étend dans un plan principal qui est le plan de la membrane 2 lorsque celle-ci est plane comme sur la figure 1A en position de repos. Dans d'autres configurations, la zone centrale 2.1 de la membrane 2 pourrait être bombée au repos et la zone intermédiaire 2.2, elle, serait sensiblement plane.

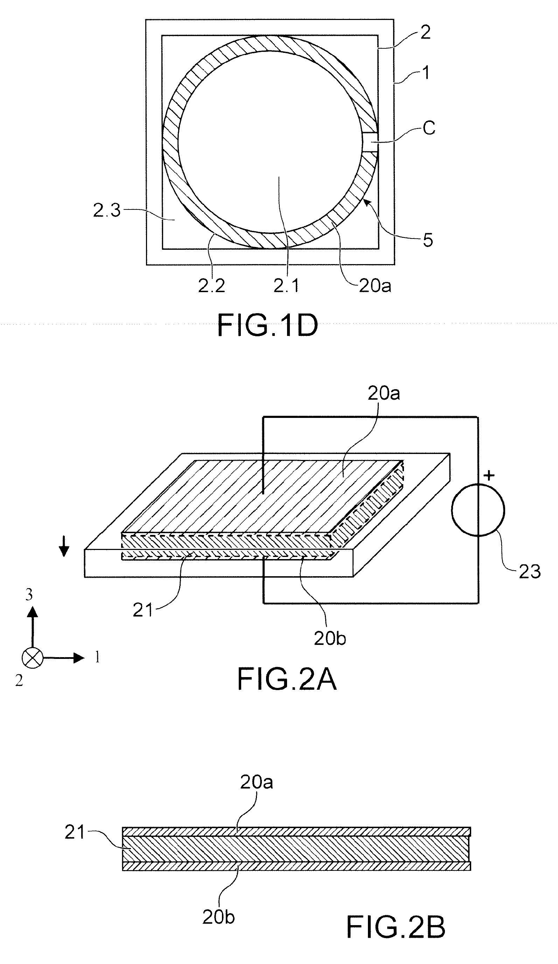

On rappelle, en se référant aux figures 2A, 2B, qu'un actionneur piézoélectrique comporte un bloc 21 de matériau piézoélectrique pris en sandwich totalement ou partiellement entre deux électrodes 20a, 20b destinées, lorsqu'elles sont alimentées, à appliquer un champ électrique interne au matériau piézoélectrique. La flèche représente la polarisation interne du matériau piézoélectrique réalisée éventuellement lors du procédé de fabrication. Une source d'alimentation porte la référence 23. Ce champ électrique est utilisé pour commander une déformation mécanique du bloc 21 de matériau piézoélectrique. Le bloc 21 de matériau piézoélectrique peut être monocouche ou multicouche et s'étendre au-delà d'une électrode. Les électrodes 20a, 20b situées de part et d'autre du bloc 21 de matériau piézoélectrique sont visibles sur les figures 2A, 2B. On a ainsi décrit l'effet piézoélectrique inverse.

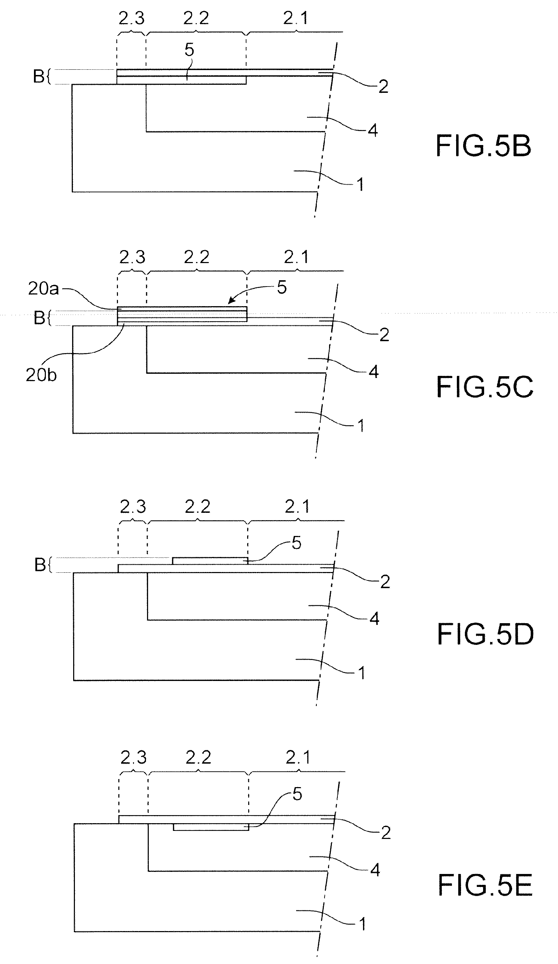

On n'a représenté les électrodes sur la couronne continue C en matériau piézoélectrique que sur certaines figures, notamment la figure 5C, la raison en est que leur épaisseur peut être négligeable par rapport à celle du matériau piézoélectrique et aussi de la membrane 2. Lorsqu'on les a représentées, les électrodes 20a, 20b sont situées sur les deux faces principales opposées de la couronne continue C en matériau piézoélectrique, ces faces principales étant sensiblement normales à l'axe optique du dispositif optique.

Sur la figure 2A, on a représenté l'allure du bloc 21 en matériau piézoélectrique avant et après l'application d'une tension de polarisation sur les électrodes 20a, 20b. Après l'application de la tension de polarisation, le bloc 21 s'est allongé dans le plan des électrodes et s'est contracté transversalement à ce plan ou inversement selon le signe de la polarisation.

Dans la présente invention, les moyens d'actionnement piézoélectriques 5 sont ancrés directement à la membrane 2 dans la zone intermédiaire 2.2, mais ils peuvent en plus être ancrés à la membrane 2 dans la zone d'ancrage 2.3. Ce n'est bien sûr pas une obligation. Par contre ils sont dépourvus d'ancrage à la membrane 2 dans la zone centrale 2.1.

Les moyens d'actionnement piézoélectriques 5 et la membrane 2 lorsqu'ils sont solidaires forment au moins un bimorphe piézoélectrique B, ce bimorphe piézoélectrique étant soit hétérogène, soit homogène. Plus précisément, chaque actionneur piézoélectrique et la membrane avec laquelle il est solidaire, forment un bimorphe piézoélectrique. On rappelle qu'un bimorphe piézoélectrique comporte une couche de matériau piézoélectrique, équipée d'électrodes, accolée à une couche qui est en matériau piézoélectrique, lorsque le bimorphe est homogène ou en matériau non piézoélectrique lorsque le bimorphe est hétérogène. Dans notre cas, cette couche en matériau piézoélectrique ou non est une couche de la membrane 2.

Lors de l'application de la tension de polarisation aux électrodes 20a, 20b d'un actionneur piézoélectrique 5.1, la couronne continue C en matériau piézoélectrique qui l'accueille, se contracte ou s'étend radialement selon la polarisation qui est appliquée aux électrodes 20a, 20b, cette déformation ayant pour effet de déplacer le fluide et donc de changer la courbure de la membrane 2 dans la zone centrale 2.1. Cela revient à dire que la différence entre le rayon extérieur et le rayon intérieur de la couronne continue C varie au niveau des électrodes 20a, 20b lorsqu'on les soumet à une tension de polarisation. On verra ultérieurement que l'effet direct peut aussi être exploité dans le dispositif optique objet de l'invention.

Le positionnement des électrodes 20a, 20b nécessaires pour obtenir la déformation voulue correspond à un couplage transversal du matériau piézoélectrique. Mais il est bien entendu qu'un autre mode de couplage peut être retenu, par exemple longitudinal ou de cisaillement.

Sur la figure 1A, on a représenté en trait continu fin, le profil de la membrane 2 lorsqu'elle a été déformée par les moyens d'actionnement 5. La déformation fait qu'une plus grande épaisseur de fluide 4 se trouve au niveau de la zone centrale 2.1 et qu'une moins grande épaisseur de fluide 4 se trouve au niveau de la zone intermédiaire 2.2. Ces constatations ont été faites en comparaison avec le profil sensiblement plan de la membrane 2 en position de repos. Sur cette figue 1A, la membrane 2 a une courbure convexe au niveau de la zone centrale 2.1 et concave au niveau de la zone intermédiaire 2.2 lorsqu'elle a été déformée. Sur la figure 1C, on a représenté en trait continu fin, le profil d'une membrane 2 ayant une souplesse moindre que celle illustrée à la figure 1A. Elle a été déformée par les mêmes moyens d'actionnement 5 soumis à une même tension d'actionnement. Sa déformée a une amplitude maximale bien moins importante que dans le cas précédent que ce soit dans la zone centrale 2.1 ou dans la zone intermédiaire 2.2.

Sur les figures 1A à 1C, on a indiqué que les moyens d'actionnement 5 ne comportaient qu'un seul actionneur piézoélectrique. Cela signifie que l'on n'a prévu qu'une seule paire d'électrodes piézoélectriques 20a, 20b supportée par la couronne continue C. Les électrodes de la paire sont situées de part et d'autre de la couronne continue en matériau piézoélectrique C, l'une 20a étant sus-jacente à la couronne continue C et l'autre sous jacente et non visible.

Les deux électrodes 20a, 20b de la paire prennent la forme d'une couronne continue circulaire sensiblement calquée sur celle en matériau piézoélectrique. En fait sur la figure 1B, on ne voit que l'électrode sus-jacente 20a, la couronne continue en matériau piézoélectrique et l'électrode sus-jacente sont masquées. Il aurait été possible que l'une des électrodes, au moins, soit en forme de portion de couronne, en d'autres termes soit en forme de couronne fendue comme sur la figure 1D. Il s'agit de l'électrode 20a. Ainsi, l'une des électrodes de l'actionneur piézoélectrique unique ne couvre pas forcément toute la face du matériau piézoélectrique sur laquelle elle se trouve. Une telle configuration facilite un actionnement dissymétrique. La configuration de la figure 1B amène bien sûr une plus grande efficacité.

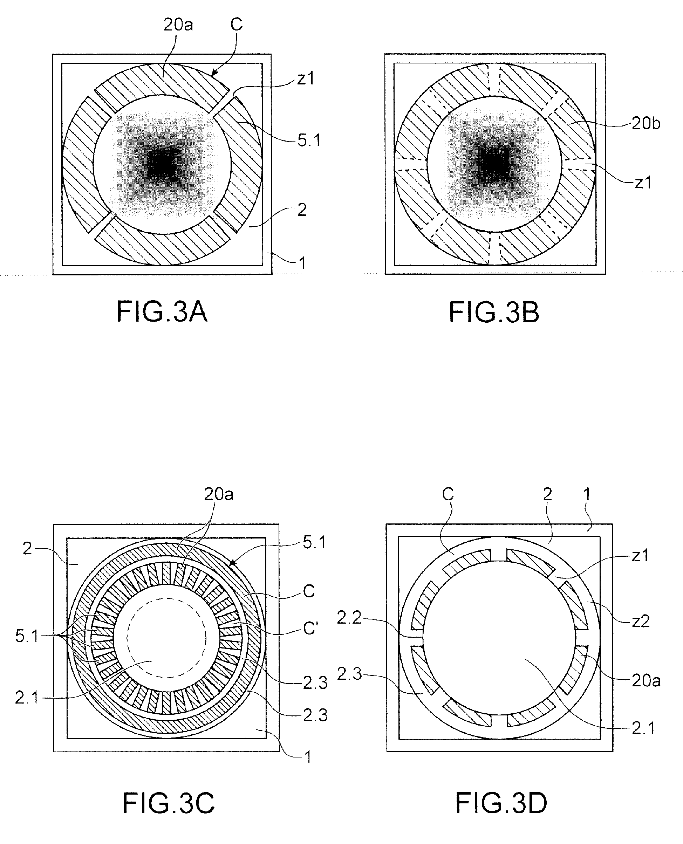

On va maintenant s'intéresser à un dispositif optique selon l'invention en se référant aux figures 3A à 3E. Le dispositif optique objet de l'invention est comparable à celui représenté aux figures 1, à l'exception du fait que les moyens d'actionnement comportent au moins une couronne continue en matériau piézoélectrique regroupant plusieurs actionneurs piézoélectriques, chaque actionneur comportant une paire d'électrodes prenant en sandwich la couronne continue.

Dans les configurations des figures 3A, 3B, on ne trouve qu'une seule couronne continue C en matériau piézoélectrique. Sur la figure 3A, il y a quatre actionneurs piézoélectriques 5.1. On distingue quatre électrodes 20a en secteurs de couronne sus-jacentes à la couronne continue C. Dans cet exemple, les quatre électrodes 20a sont sensiblement identiques et sont disposées de manière sensiblement régulièrement sur la couronne continue C en matériau piézoélectrique. Dans un cas général, on trouverait également quatre électrodes en secteurs de couronne sous-jacentes à la couronne continue C en regard des quatre électrodes sus-jacentes. C'est pour cela que l'on n'a pas représenté les électrodes sous-jacentes correspondant à ce cas.

Sur la figure 3B, on a représenté huit électrodes 20b en secteurs de couronne sous-jacentes. Dans ces deux figures 3A, 3B, des zones radiales z1 entre deux secteurs de couronne continue laissent apparaître le matériau piézoélectrique du bimorphe piézoélectrique. Ces deux figures peuvent montrer les deux faces opposées des moyens d'actionnement d'un même dispositif optique objet de l'invention. On dispose alors de huit actionneurs piézoélectriques.

Sur la figure 3C, on a représenté des moyens d'actionnement piézoélectriques comportant deux couronnes continues C, C' en matériau piézoélectrique dont au moins une accueille plusieurs actionneurs piézoélectriques 5.1. Les deux couronnes continues C, C' sont concentriques, la couronne continue C' étant interne et la couronne continue C étant externe. On suppose que la couronne continue C empiète sur la zone d'ancrage 2.3 de la membrane 2 mais pas la couronne continue C'. La membrane 2 est circulaire. On a représenté une pluralité d'actionneurs piézoélectriques 5.1 sur la couronne continue interne C' et un seul sur la couronne continue externe C. Sur la figure 3C, les électrodes sus-jacentes 20a des actionneurs piézoélectriques 5.1 situés sur la couronne continue C' interne, sont des plages allongées radiales. On ne voit pas les électrodes sous-jacentes.

Dans les cas des figures 1A, 3A, 3B, les électrodes en secteurs de couronne ont des rayons intérieurs et extérieurs qui sont sensiblement les mêmes que ceux de la couronne continue C en matériau piézoélectrique qui les supporte. Il est possible que les électrodes 20a ou 20b en secteurs de couronne aient au moins un rayon intérieur ou extérieur qui soit différent du rayon intérieur ou extérieur de la couronne continue C en matériau piézoélectrique. On se réfère à la figure 3D

Cela signifie qu'au moins une zone longitudinale z2 laisse apparaître le matériau piézoélectrique de la couronne continue C.

On comprendra qu'un grand nombre de variantes existe pour placer les électrodes sur une face de la couronne continue en matériau piézoélectrique.

Les deux électrodes 20a, 20b d'une paire dans un actionneur piézoélectrique n'ont pas besoin d'être identiques. Notamment, plusieurs actionneurs piézoélectriques peuvent partager une même électrode comme on l'a déjà illustré sur les figures 3A, 3B. Cette électrode commune peut servir à tous les actionneurs piézoélectriques ou à certains d'entre eux par exemple.

On peut envisager par exemple que deux actionneurs piézoélectriques voisins partagent une même électrode. C'est ce que l'on a voulu illustrer aux figures 3A et 3B. Deux actionneurs piézoélectriques partagent une même électrode 20a, par contre ils possèdent leur propre électrode 20b.

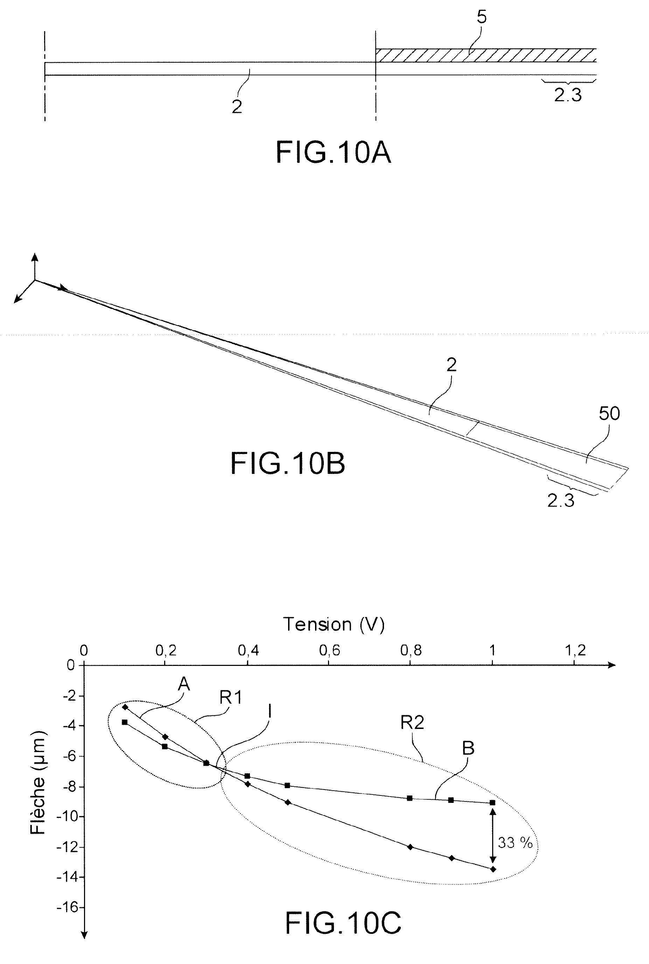

Chaque paire d'électrodes 20a, 20b peut être alimentée de manière indépendante des autres, ce qui signifie que toutes les paires d'électrodes peuvent être soumises à des tensions différentes. Ainsi la déformation de la membrane 2 dans la zone centrale 2.1 peut être antisymétrique, non axisymétrique et de très nombreuses possibilités de déformation existent. Mais le fait que la couronne C en matériau piézoélectrique soit continue fait que sa surface ancrée sur la membrane est grande, ce qui assure une efficacité accrue de l'actionnement, sans se pénaliser du point de vue rigidité en flexion comme l'illustre la figure 10C.

Le fait d'utiliser des électrodes discontinues 20a, 20b sur au moins une des faces de la couronne continue C en matériau piézoélectrique, dans une lentille utilisée dans un appareil de type appareil photo ou caméra, permet d'adresser simplement la thématique « correction du bougé » en proposant une déformation du dioptre de la lentille aussi bien axisymétrique, anti-axisymétrique ou autre.

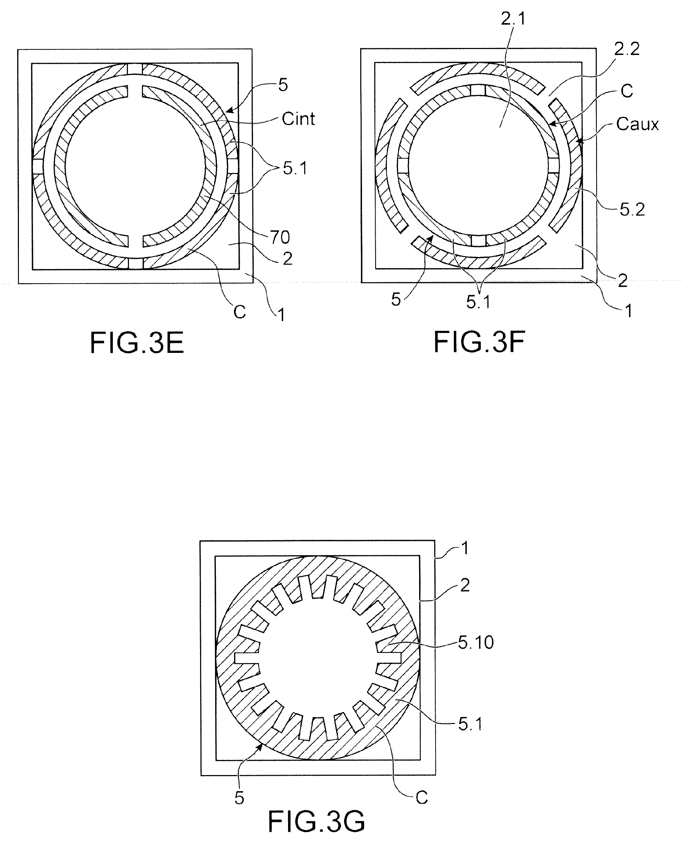

Il est possible d'utiliser l'effet piézoélectrique direct pour surveiller la déformation de la membrane 2 lorsqu'il y plusieurs actionneurs piézoélectriques 5.1. On peut acquérir la tension qui apparait aux bornes d'un des actionneurs piézoélectriques non actionné alors que d'autres actionneurs piézoélectriques d'une même couronne continue sont actionnés. Il est également possible de prévoir un ou plusieurs actionneurs piézoélectriques aptes à fonctionner passivement par effet piézoélectrique direct, agencés en couronne spécialement dédiés à cette surveillance comme illustré sur la figure 3E. La couronne interne Cint en matériau piézoélectrique accueille au moins un actionneur piézoélectrique passif 70 détectant la déformation locale de la membrane 2 par effet direct. La couronne interne Cint peut être continue ou morcelée, chacun des morceaux accueillant un ou plusieurs actionneurs piézoélectriques destinés à fonctionner par effet direct. La couronne interne Cint est ancrée à la membrane 2 dans la zone intermédiaire 2.2, elle n'empiète pas sur la zone centrale 2.1, ni sur la zone d'ancrage 2.3. Ce n'est qu'un exemple, les actionneurs dédiés à la surveillance pourraient être ancrés sur la zone d'ancrage de la membrane. Sur l'exemple de la figure 3E, la couronne interne Cint est morcelée en deux morceaux, chacun accueillant un actionneur piézoélectrique passif 70. Il est bien sûr possible qu'un même actionneur piézoélectrique soit destiné à déformer la membrane par intermittence et soit destiné à surveiller la déformation de la membrane par intermittence. Il peut ainsi être passif à certains moments et actif à d'autres.

Encore une variante serait d'utiliser au lieu d'un actionneur piézoélectrique une jauge de contrainte d'un autre type pour surveiller la déformation de la membrane.

Les moyens d'actionnement 5 sont formés de plusieurs actionneurs piézoélectriques élémentaires 5.1 agencés sur la couronne continue C en matériau piézoélectrique. La couronne continue C est située autour de la couronne interne Cint. Les actionneurs piézoélectriques 5.1 sont actionnables par effet inverse.

Il est également possible que le dispositif optique comporte des moyens d'actionnement auxiliaires 5' avec au moins une couronne auxiliaire discontinue Caux en matériau piézoélectrique accueillant plusieurs actionneurs piézoélectriques auxiliaires 5.2 fonctionnant par effet inverse. La couronne auxiliaire Caux est montée concentriquement avec la couronne continue C. Elle peut être située à l'extérieur comme sur la figure 3F ou à l'intérieur. Dans un souci de ne pas multiplier inutilement les figures, la variante avec la couronne auxiliaire intérieure n'a pas été représentée. Mais on peut se référer à la figure 3E pour se rendre compte de l'allure qu'aurait une telle configuration si les actionneurs 70 fonctionnaient par effet inverse. Cette couronne auxiliaire Caux est ancrée à la membrane 2 dans la zone intermédiaire 2.2, elle peut empiéter sur la zone d'ancrage 2.3 mais pas sur la zone centrale 2.1. Les moyens d'actionnement auxiliaires 5' forment également avec la membrane 2 au moins un bimorphe piézoélectrique.

On peut envisager en se référant à la figure 3G que les moyens d'actionnement 5 comprennent une couronne continue C accueillant plusieurs actionneurs piézoélectriques et que cette couronne continue C soit dotée sur l'une de ses périphéries de barreaux orientés radialement, ces barreaux accueillant des actionneurs piézoélectriques élémentaires 5.10. Les barreaux peuvent ainsi être orientés vers l'intérieur de la couronne C ou vers l'extérieur.

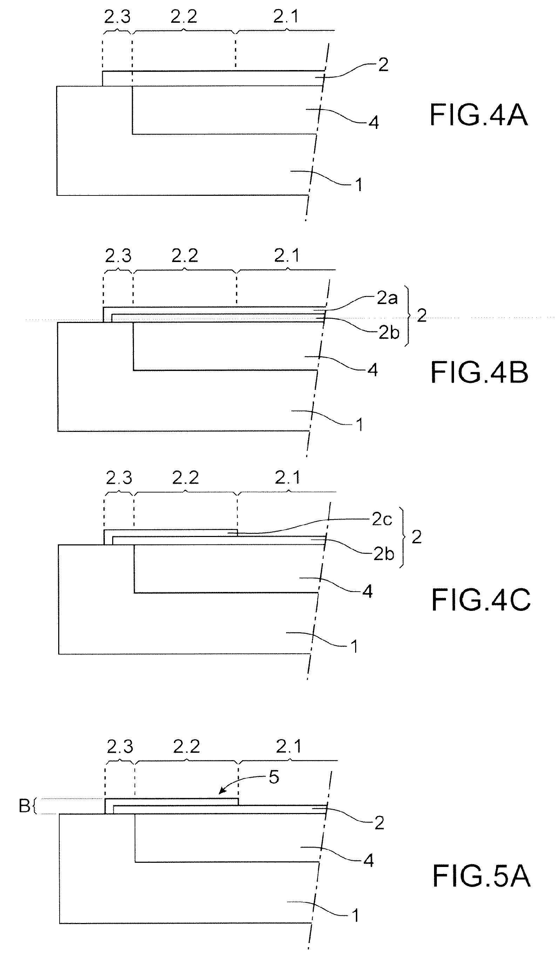

Nous allons maintenant, en se référant aux figures 4A à 4C, donner quelques caractéristiques de la membrane 2. Cette membrane 2 comporte au moins trois zones comme on l'a déjà exposé appelées zone d'ancrage 2.3, zone intermédiaire 2.2 et zone centrale 2.1 en se déplaçant depuis son bord vers son centre. La zone intermédiaire 2.2 est celle qui est directement sollicitée par les moyens d'actionnement 5 et éventuellement par les moyens d'actionnement auxiliaires. La zone centrale 2.1 dédiée au champ optique est déformée par les mouvements du fluide 4. Cette déformation étant réversible, le matériau de cette zone centrale 2.1 travaillera dans le domaine de la déformation élastique. Sa transparence ou au contraire ses propriétés réflectrices sont choisies selon que le dispositif optique est une lentille ou un miroir. Il est possible que la membrane 2 soit monocouche et homogène depuis la zone centrale 2.1 jusqu'à la zone d'ancrage 2.3 (figure 4A). Elle peut en variante être multicouche comme sur la figure 4B, les deux couches étant référencées 2a, 2b. Elle possède deux couches superposées 2a, 2b dans la zone centrale 2.1, dans la zone intermédiaire 2.2 et dans une partie de la zone d'ancrage 2.3. Dans cette zone d'ancrage 2.3, la couche sus-jacente 2a de l'empilement se prolonge directement sur le support 1 au delà de la couche sous-jacente 2b.

La zone d'ancrage 2.3 de la membrane 2 doit posséder, elle, des propriétés d'adhérence sur le support 1. La couche sus-jacente 2a de la figure 4B peut être choisie pour avoir de meilleures propriétés d'adhérence sur le support 1 que la couche sous-jacente 2b.

La zone intermédiaire 2.2 de la membrane 2 peut avoir des propriétés permettant d'accentuer la déformation induite par les moyens d'actionnement 5, ce qui signifie qu'on la choisira de préférence avec une rigidité supérieure à celle de la zone centrale 2.1. Il y a une interaction entre la membrane 2 et les moyens d'actionnement 5 dans la zone intermédiaire 2.2 puisque c'est dans cette zone que se trouve le bimorphe piézoélectrique.

Le sens du fléchissement de la membrane 2 dans la zone centrale 2.1 dépend de la différence de propriétés mécaniques entre le matériau piézoélectrique et le ou les matériaux de la membrane 2 sur lesquels la couronne continue en matériau piézoélectrique est ancrée. Le sens de la polarisation et la position de la couronne continue en matériau piézoélectrique ont aussi leur importance.

La membrane 2 peut donc être hétérogène avec au moins une couche dite principale 2b qui occupe la zone centrale 2.1 et qui s'étend de manière continue sur toute la surface de la membrane 2 et au moins une couche de renfort 2c qui ne s'étend que sur une partie de la membrane 2 dont au moins la zone intermédiaire 2.2. Sur la figure 4C qui illustre ce cas, la couche principale 2b s'étend sur toute la surface de la membrane 2 et la couche de renfort 2c s'étend, dans cet exemple, sur la zone d'ancrage 2.3 et sur la zone intermédiaire 2.2. La couche de renfort 2c empiète directement sur le support 1 de la même manière qu'à la figure 4B. Sur les figures 4A à 4C, on a omis de représenter les moyens d'actionnement 5.

On va maintenant passer en revue de l'agencement entre la membrane 2 et les moyens d'actionnement 5 dans la mesure où les moyens d'actionnement 5 sont ancrés sur la zone d'ancrage 2.3 en plus d'être ancrés sur la zone intermédiaire 2.2. On se réfère aux figures 5A à 5C. Sur ces figures la membrane 2 est représentée monocouche, mais cela n'est pas limitatif. C'est cette couche de la membrane 2 qui contribue à former le bimorphe piézoélectrique B. Sur la figure 5A, les moyens d'actionnement 5 sont sus-jacents à la membrane 2, ils s'étendent sur la zone intermédiaire 2.2 et la zone d'ancrage 2.3 et se prolongent directement sur le support 1. Ils sont sans contact avec le fluide 4 emprisonné entre la membrane 2 et le support 1. Sur la figure 5B, ils sont sous-jacents à la membrane 2 et de la même manière s'étendent sur la zone intermédiaire 2.2 et la zone d'ancrage 2.3 mais n'empiètent pas sur le support 1. Il est bien sûr possible qu'ils empiètent sur le support 1. Ils sont en contact avec le fluide 4 emprisonné entre le support 1 et la membrane 2. Sur ces deux figures l'ancrage est direct entre les moyens d'actionnement 5 et le support 1.

Sur la figure 5C, les moyens d'actionnement 5 sont sus-jacents à la membrane 2, ils s'étendent sur la zone intermédiaire 2.2 et sur la zone d'ancrage 2.3, éventuellement de manière partielle, mais n'empiètent pas directement sur le support 1. Ils ne sont pas en contact avec le fluide 4 emprisonné entre la membrane 2 et le support 1. Dans ce dernier cas l'ancrage entre les moyens d'actionnement 5 et le support 1 est indirect. Sur cette figure on a représenté les électrodes 20a, 20b des moyens d'actionnement.

On va maintenant s'intéresser aux figures 5D, 5E qui montrent deux cas où les moyens d'actionnement 5 ne sont pas ancrés au support 1. Ils n'empiètent donc pas sur la zone d'ancrage 2.3 de la membrane 2. Ici encore la membrane 2 est monocouche, mais elle pourrait être multicouche. Sur la figure 5D, les moyens d'actionnement 5 sont sus-jacents à la membrane 2. Ils sont sans contact avec le fluide 4 emprisonné entre la membrane 2 et le support 1. Sur la figure 5E, les moyens d'actionnement 5 sont sous-jacents à la membrane 2, ils sont en contact avec le fluide 4 emprisonné entre la membrane 2 et le support 1.

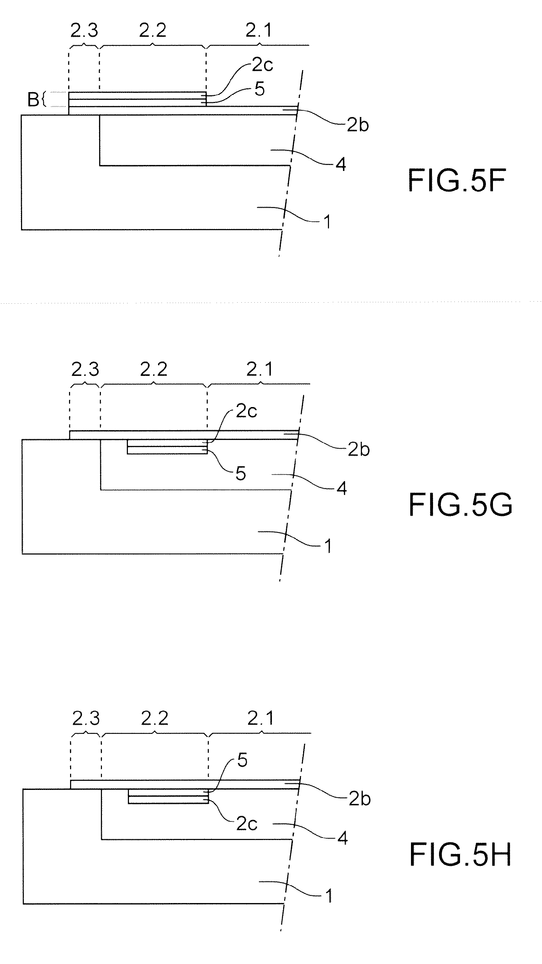

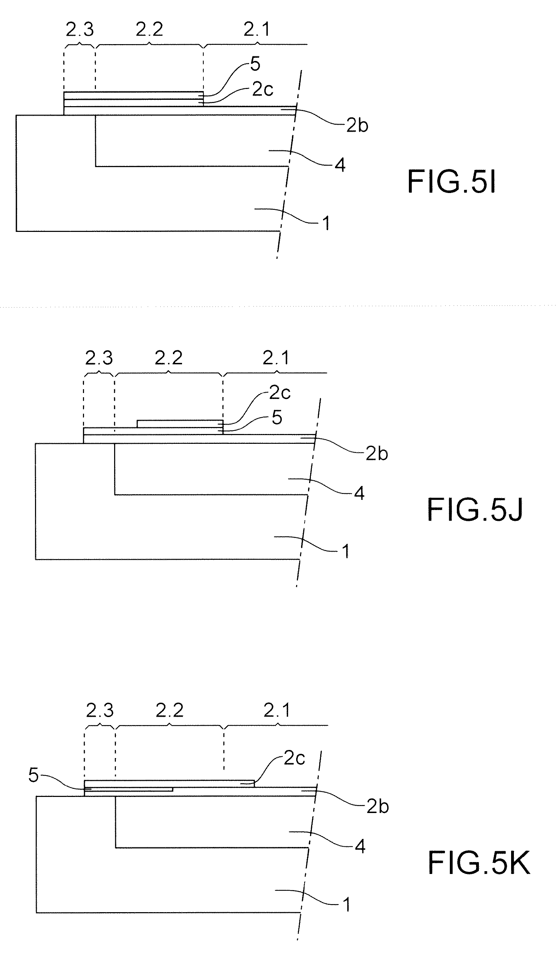

On va maintenant montrer sur les figures 5F 5I, des exemples sur lesquels la membrane comporte une couche principale 2b qui s'étend de manière continue de la zone centrale 2.1 à la zone d'ancrage 2.3 et, au niveau de la zone intermédiaire 2.2, une couche de renfort 2c qui peut être sus-jacente à la couche principale 2b comme sur les figures 5F, 5I ou sous-jacente comme sur les figures 5G, 5H. Sur la figure 5F, les moyens d'actionnement 5 sont insérés entre la couche principale 2b et la couche de renfort 2c. Les moyens d'actionnement 5 et la couche de renfort 2c sont sans contact avec le fluide 4 emprisonné entre la membrane 2 et le support 1. La couche de renfort 2c est plus rigide que la couche principale 2b, c'est elle qui va contribuer à former le bimorphe piézoélectrique B. La couche principale 2b devient passive au regard des phénomènes mécaniques mis en jeu. La couche principale 2b est configurée pour être aussi souple que possible de manière à éviter une surconsommation en énergie lors de l'actionnement pour obtenir une déformée donnée. On a représenté sur les figures 1A et 1C des déformées différentes pour une même consommation d'énergie et des souplesses différentes de membrane 2.

Sur la figure 5G, la couche de renfort 2c est insérée entre les moyens d'actionnement 5 et la couche principale 2b. Les moyens d'actionnement 5 et la couche de renfort 2c sont en contact avec le fluide 4 emprisonné entre la membrane 2 et le support 1.

Sur la figure 5H, les moyens d'actionnement 5 sont insérés entre la couche de renfort 2c et la couche principale 2b de la membrane 2. Les moyens d'actionnement 5 et la couche de renfort 2c sont en contact avec le fluide 4 emprisonné entre la membrane 2 et le support 1.

Sur la figure 5I, la couche de renfort 2c est insérée entre les moyens d'actionnement 5 et la couche principale 2b. Les moyens d'actionnement 5 et la couche de renfort 2c sont sans contact avec le fluide 4 emprisonné entre la membrane 2 et le support 1.

Sur les figures 5F et 5I, les moyens d'actionnement 5 sont ancrés de manière indirecte au support 1.

Sur la figure 5J, les moyens d'actionnement 5 sont sus-jacents à la couche principale 2b de la membrane 2, ils sont ancrés sur le support 1, ils s'étendent sur la zone d'ancrage 2.3 de la membrane 2. La couche de renfort 2c, elle, est sus-jacente aux moyens d'actionnement 5, elle ne s'étend que sur la zone intermédiaire 2.2 et n'empiète pas sur la zone d'ancrage 2.3.

Sur la figure 5K, la couche principale 2b de la membrane 2 est plus épaisse dans la zone centrale 2.1 que dans la zone intermédiaire 2.2 et dans la zone d'ancrage 2.3. Les moyens d'actionnement 5 sont sus-jacents à la couche principale 2b, ils s'étendent dans une partie seulement de la zone intermédiaire 2.2, une partie la plus éloignée de la zone centrale 2.1, et dans la zone d'ancrage 2.3. L'épaisseur des moyens d'actionnement 5 et de la couche principale 2b dans la zone intermédiaire 2.2 et dans la zone d'ancrage 2.3 est sensiblement égale à celle de la couche principale 2b dans la zone centrale 2.1. La couche de renfort 2c est sus-jacente aux moyens d'actionnement 5, elle s'étend dans toute la zone intermédiaire 2.2, elle s'étend au-delà des moyens d'actionnement 5.

Il est toutefois possible que la couche de renfort 2c s'étende dans la zone centrale 2.1 comme sur la figure 5K si ses propriétés optiques de réflexion ou de transmission sont compatibles avec l'application du dispositif optique, c'est-à-dire avec la lentille ou le miroir. Il faut bien sûr dans ce cas que la déformée de la membrane au niveau de la couche de renfort 2c soit compatible avec ce qui est recherché comme déformée pour la membrane.

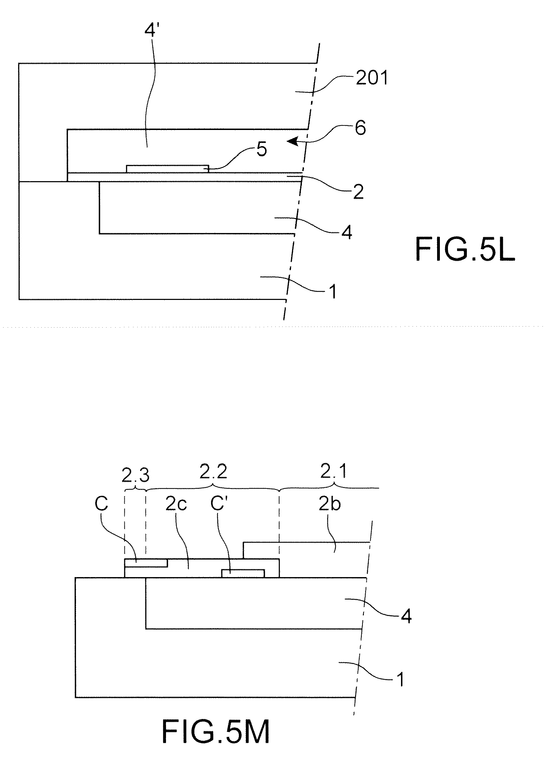

Sur la figure 5M, il y a une couche de renfort 2c et la couche principale 2b présente au niveau de la zone centrale 2.1 n'est pas continue jusqu'à la zone d'ancrage 2.3 comme précédemment. Elle s'étend au niveau de la zone intermédiaire 2.2 mais s'arrête avant la zone d'ancrage 2.3. La couche de renfort 2c prend alors le relais. Ici encore cette couche 2b qui s'étend au niveau de la zone centrale 2.1 est plus épaisse au niveau de la zone centrale 2.1 qu'au niveau de la zone intermédiaire 2.2. L'assemblage entre la couche de renfort 2c et la couche principale 2b qui occupe la zone centrale 2.1 doit être suffisamment étanche de manière à ce que le fluide 4 que le support 1 et la membrane 2 contribuent à emprisonner ne puisse s'échapper de la cavité, même lorsque les moyens d'actionnement 5 sont actionnés. Sur cette figure les moyens d'actionnement sont comparables à ceux illustrés sur la figure 3C, l'une des couronnes référencée C est sus-jacente à la membrane 2 et l'autre référencée C'est sous-jacente.

La figure 5L est encore un autre exemple de dispositif optique selon l'invention dans lequel les moyens d'actionnement 5 sont sans contact avec le fluide 4 emprisonné entre le support 1 et la membrane 2, ils sont sus-jacents à la membrane 2 qui est monocouche.

Il est possible que la membrane 2, pourvue des moyens d'actionnement 5, soit coiffée d'un capot de protection 201 qui est scellé au support 1 comme illustré sur la figure 5L. Ce capot 201 délimite une cavité 6. La fixation peut se faire par exemple par collage moléculaire, par collage organique, par collage anodique, par collage eutectique une couche d'alliage par exemple en Au/Si ou Au/Sn par exemple étant intercalée entre le capot 201 et le support 1 à sceller. Ces techniques de collage sont couramment utilisées dans le domaine de la microélectronique et des microsystèmes.

Le capot 201 délimite une cavité 6 dans laquelle est emprisonné un second fluide 4', la face supérieure de la membrane 2, c'est-à-dire celle qui n'est pas en contact avec le premier fluide 4, est en contact avec le second fluide 4'. Le capot 201, au moins dans sa partie centrale, et le second fluide 4' doivent être transparents pour le rayonnement optique incident qui va soit se réfléchir sur la membrane 2, soit la traverser selon la nature du dispositif optique.

Le capot 201 peut être réalisé en verre ou en matériau organique tel que le polyéthylène téréphtalate PET, le polyéthylène naphtalate, le polymétacrilate de méthyle PMMA, le polycarbonate PC s'il doit transmettre des longueurs d'ondes dans le visible. Le capot 201 assure une protection de la membrane 2 car de tels dispositifs optiques à membrane 2 déformable sont des objets fragiles dont la manipulation est délicate.

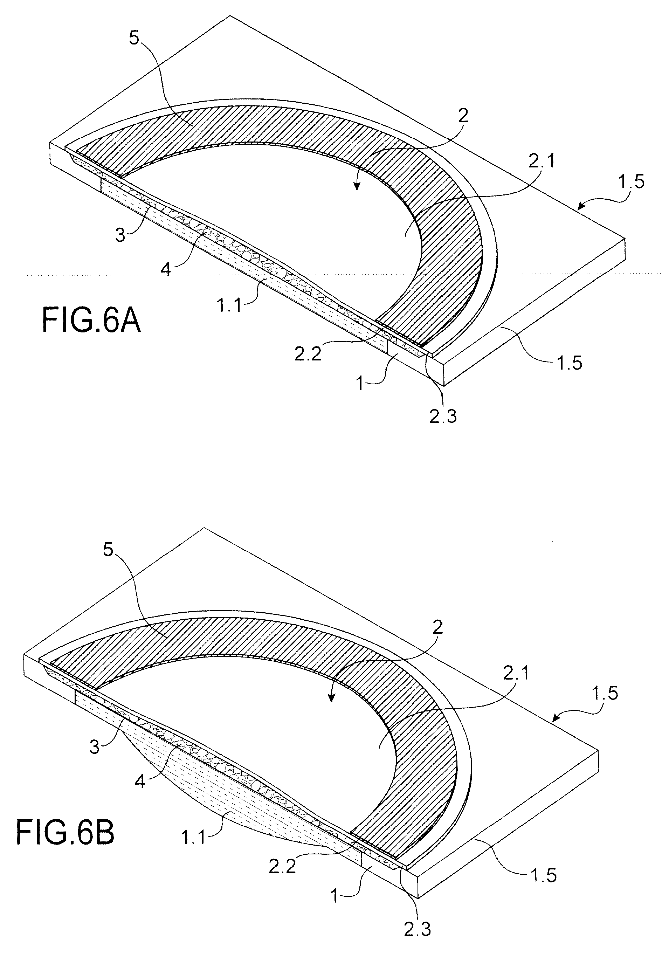

Le support 1 peut être monolithique comme on l'a représenté depuis le début de cette description. En variante illustrée sur la figure 6A, il peut être formé par un cadre 1.5 solidaire d'une plaque 1.1 pour former la cuvette 3. La plaque 1.1 matérialise le fond de la cuvette 3, elle est transparente à un rayonnement optique qui va la traverser ou peut être réfléchissante dans le cas d'un miroir. Il n'y a pas de modification au niveau de la membrane 2, des moyens d'actionnement, du fluide 4 par rapport à ce qui a été décrit précédemment.

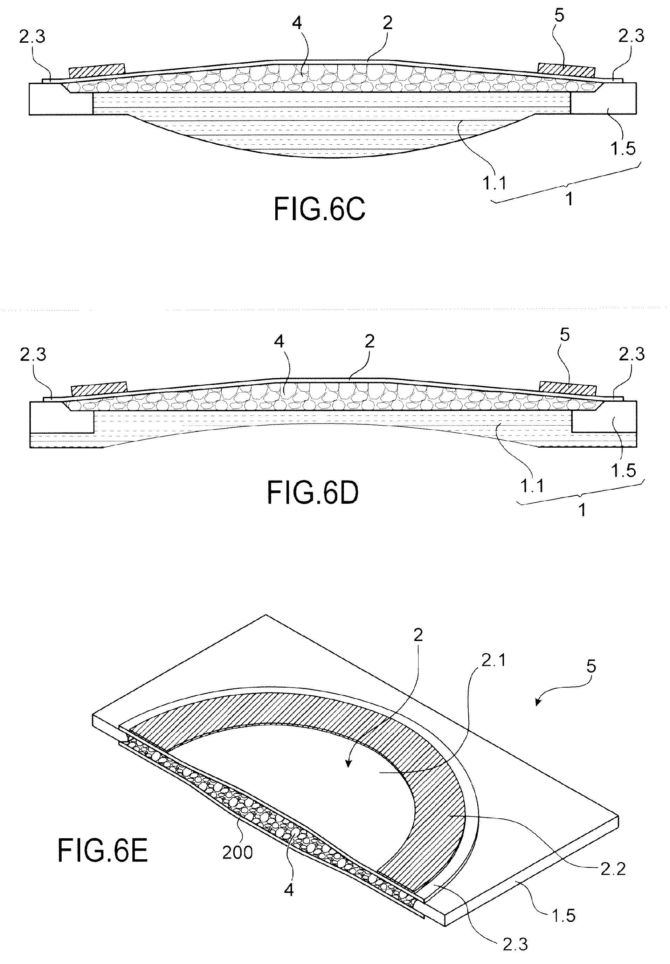

La plaque transparente 1.1 peut être d'épaisseur sensiblement constante, à faces sensiblement parallèles planes, comme sur la figure 6A. Au moins une face pourrait être structurée comme sur les figures 6B, 6C, 6D, où la face extérieure est convexe ou concave. Le choix se fait en fonction des performances optiques recherchées pour le dispositif optique. Elle laisse passer un rayonnement optique qui traversera la lentille. Le cadre 1.5 peut être en matériau semi-conducteur tel que le silicium, ce qui le rend apte à intégrer des circuits associés au traitement de la commande des moyens d'actionnement 5. Les circuits ne sont pas représentés pour ne pas surcharger les figures. La plaque transparente 1.1 peut être en verre ou en matière plastique.

Sur les figures 6B, 6C, la plaque transparente 1.1 est à structure convexe et sur la figure 6D, elle est à structure concave. La structuration de la plaque 1.1 transparente peut être obtenue par usinage ou par moulage par exemple.

Sur la figure 6E, le support 1 est matérialisé par le cadre 1.5 et la plaque transparente 1.1 est remplacée par une seconde membrane 200. La seconde membrane 200 comporte une couche qui a sensiblement la même surface que la première membrane 2. Les deux membranes 2, 200 sont ancrées sur le cadre 1.5, chacune sur une de ses faces principales. Elles contribuent à réaliser un logement pour le liquide 4. Cela permet d'accroître les performances optiques de la membrane 2. Les moyens d'actionnement 5 sont prévus sur une seule des membranes 2. L'autre membrane 20 n'est pas actionnée, mais elle se déforme quand même lorsque les moyens d'actionnement 5 sont actionnés.

En variante, on peut envisager que des seconds moyens d'actionnement soient prévus pour actionner l'autre membrane 200.

Le dispositif optique peut être réalisé par des techniques connues en microélectronique. On peut utiliser des techniques de dépôt en couche mince de type dépôt chimique en phase vapeur, de type dépôt physique par phase vapeur d'électrodéposition, d'épitaxie, d'oxydation thermique, d'évaporation, de laminage de films. Les matériaux organiques ou de type sol gel peuvent être déposés par pulvérisation à la tournette. Des techniques de moulage, d'embossage, de gaufrage à chaud, de nano impression, peuvent être employées pour structurer la face inférieure du substrat comme illustré aux figures 6B à 6D. Des techniques de collage peuvent aussi être utilisées pour le collage de la membrane 2 au support 1 ou d'un fond 3 au cadre 1.5 ou du capot 201 au support 1, ces techniques peuvent par exemple être choisies parmi le collage direct, le collage eutectique, le collage anodique, le collage organique. Des étapes d'amincissement par exemple par rodage, amincissement chimique ou bien combinaison des deux types peuvent être prévues après le collage du fond au cadre. Le dispositif optique peut être fabriqué par lots et tous les capots 201 des différents dispositifs peuvent être réalisés de manière collective.

La membrane 2 peut être réalisée à base de matériaux organiques tels que le polydiméthylsiloxane, le polyméthacrylate de méthyle, le polyéthylène téréphtalate, le polycarbonate, le parylène, les résines époxydes, les polymères photosensibles, les silicones telles que celles connues sous la dénomination SiNR de chez Shin-Etsu ou sous la dénomination WL5150 de chez Dow Corning ou de matériaux minéraux, tels que le silicium, l'oxyde de silicium, le nitrure de silicium, le carbure de silicium, le silicium polycristallin, le nitrure de titane, le carbone diamant, l'oxyde d'étain et d'indium, l'aluminium, le cuivre, le nickel. On peut également envisager d'employer du caoutchouc naturel ou synthétique au moins pour la couche qui occupe la zone centrale car ils permettent d'importantes déformations élastiques. La couche de renfort pourrait être réalisée dans un matériau piézoélectrique choisis parmi ceux cités pour la couronne continue. Le bimorphe piézoélectrique serait alors homogène. La membrane a une épaisseur allant du micron jusqu'au millimètre. L'épaisseur choisie dépend du matériau utilisé et du procédé de dépôt employé. La couche de renfort aura une épaisseur comprise entre une dizaine de nanomètres et quelques micromètres.

Chacun des fluides 4, 4' peut être un liquide comme le carbonate de propylène, l'eau, un liquide d'indice, une huile optique ou encore un liquide ionique, ou tout liquide permettant d'obtenir un saut d'indice de réfraction par rapport au fluide 4 présent de l'autre côté de la membrane 2. Comme gaz, on peut citer l'air, l'azote, l'hélium par exemple.

Le matériau piézoélectrique des moyens d'actionnement 5 peut être choisi parmi le PZT soit Titano-Zirconate de Plomb de formule Pb(Zrₓ,Ti₁₋ₓ)O₃, le nitrure d'aluminium AIN, le polyfluorure de vinylidène (PVDF) et ses copolymères de trifluoroéthylène (TrFE), l'oxyde de zinc ZnO, le titanate de barium BaTiO₃, le niobate de plomb PNbO₃, le titanate de bismuth Bi₄Ti₃O₁₂ ou d'autres sillénites qui sont des oxydes avec un rapport métal/oxygène égal à 2/3. On cherche à ce que le matériau piézoélectrique ait un coefficient de couplage mécanique le plus élevé possible. L'épaisseur de la couronne en matériau piézoélectrique va de quelques centaines de nanomètres jusqu'à quelques micromètres. L'épaisseur est à adapter à la gamme de tensions de polarisation à appliquer, au champ de claquage associé du matériau piézoélectrique et aux performances optiques désirées.

Les électrodes des moyens d'actionnement peuvent être en platine, ou un bicouche platine titane si elle doit être déposée sur un oxyde, le titane servant de colle entre le platine et l'oxyde. On peut aussi utiliser de l'or ou un bicouche chrome or, le chrome servant de barrière à la diffusion de l'or. Un autre matériau qui convient est le ruthénium. Cette liste n'est pas exhaustive. Les épaisseurs caractéristiques pour les électrodes vont de quelques dizaines de nanomètres au micron environ.

Le dépôt d'une couche en matériau piézoélectrique tel que du PZT nécessite des recuits à haute température de l'ordre de 800°C. Bien souvent le matériau de la membrane ne supporte pas ces températures. Il faut donc d'abord réaliser les moyens d'actionnement en matériau piézoélectrique et les assembler ensuite à la membrane. Lors de la fabrication du dispositif optique selon l'invention, il faut prendre en compte ces contraintes lors de l'élaboration de l'empilement.

Les inventeurs se sont aperçus que puisque les différents matériaux constituants le dispositif optique, objet de l'invention, n'avaient pas le même coefficient de dilatation thermique, la distance focale du dispositif optique pouvait être amenée à changer de manière non voulue.

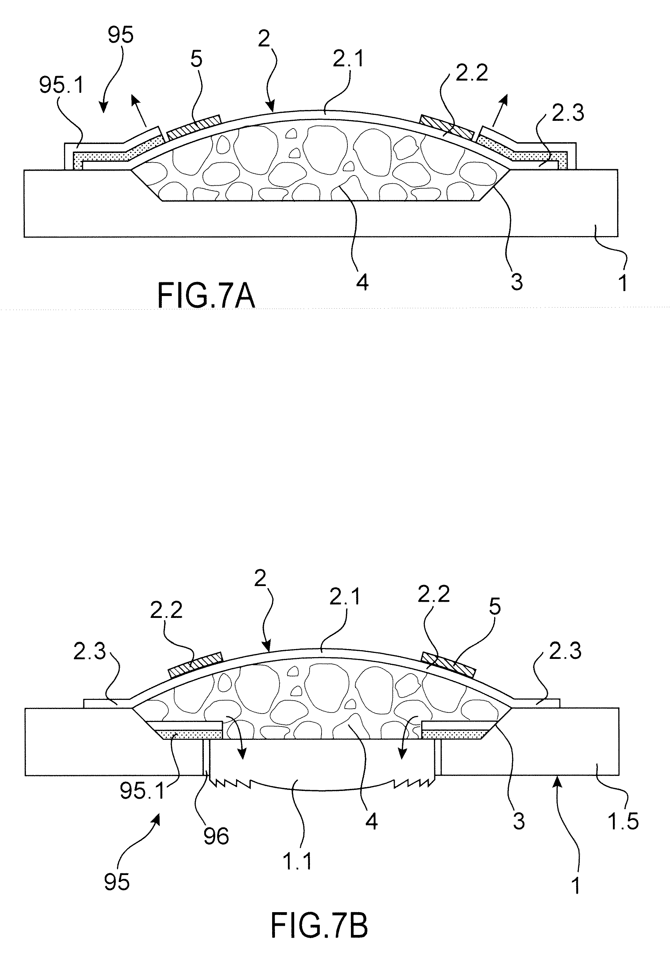

Il est donc possible de prévoir des moyens de compensation d'une variation de la distance focale due à une variation de température. On peut se référer aux figures 7A, 7B.

Ces moyens de compensation 95 sont formées d'un ou plusieurs éléments bimorphes 95.1 thermiques agencés en couronne continue ancrés à la membrane 2 au niveau de la zone d'ancrage 2.3 en débordant sur la zone intermédiaire 2.2 comme sur la figure 7A, soit au niveau du fond 3.1 de la cuvette 3 comme sur la figure 7B. Ces éléments bimorphes thermiques 95.1 sont dédiés à cette compensation. Sous l'effet d'une augmentation de la température à l'origine notamment d'une augmentation du volume du fluide 4 emprisonné entre la membrane 2 et le support 1, et donc d'une déformation non voulue de la membrane 2, les éléments bimorphes thermiques 95.1 se déforment pour augmenter le volume de la cuvette 3 en augmentant son épaisseur. Un élément bimorphe thermique 95.1 formé de deux couches superposées réalisées dans des matériaux ayant des coefficients de dilatation thermiques différents ne pose pas de problème à un homme du métier.

Dans la configuration de la figure 7B, le support 1 est similaire à celui de la figure 6B. Les éléments bimorphes thermiques 95.1 se trouvent, côté fluide 4, sur le cadre 1.5 et débordent sur la plaque transparente 1.1. La plaque transparente 1.1 est concave dans sa partie centrale et comporte des stries à sa périphérie. Un joint de dilatation 96 est inséré entre la plaque 1.1 et le cadre 1.5 pour donner de la souplesse selon l'axe optique et permettre l'augmentation du volume de la cuvette 3. L'augmentation du volume de la cuvette 3 viendra de la déformation de la membrane 2 en bordure de la zone d'ancrage 2.3 et/ou du support 1. L'objectif est qu'une dilatation du fluide 4 emprisonné entre la membrane 2 et le support 1 n'ait pas d'influence sur la flèche de la membrane 2 dans la zone centrale 2.1 et donc sur la distance focale du dispositif optique.

On peut également envisager que les moyens de compensation 95 d'une variation de la distance focale sous l'effet d'une variation de température contribuent à ce que la membrane soit soumise à une contrainte résiduelle sensiblement constante, quelles que soient les conditions climatiques. On évite ainsi que n'apparaisse un flambage ou un fripement de la membrane 2 en cas de contrainte compressive excessive ou au contraire une tension excessive ayant pour effet de dégrader les performances du dispositif optique.

Le choix du ou des matériaux de la membrane 2 est fait pour répondre à des exigences du procédé de fabrication ou pour que la lentille liquide ou le miroir atteigne certaines performances.

Le dispositif optique est d'autant plus performant pour une consommation d'énergie donnée que sa zone centrale 2.1 est souple. Un matériau organique en silicone convient particulièrement bien. Il est préférable alors de rigidifier la membrane 2 au niveau de la zone intermédiaire 2.2 en prévoyant la couche de renfort 2c, par exemple en matériau minéral tel que l'oxyde de silicium et/ou le nitrure de silicium sur la couche organique qui s'étend de la zone centrale 2.1 à la zone d'ancrage 2.3. Une membrane 2 dont la zone centrale 2.1 est en oxyde de silicium ou en nitrure de silicium conviendrait également.

On s'arrange également pour que les moyens d'actionnement 5 une fois fixés sur la membrane 2 ne perturbent pas le comportement attendu de la membrane 2. La déformée de la membrane 2 au repos doit être compatible avec l'usage que l'on veut faire du dispositif optique. La membrane 2 peut, au repos, former un dioptre sensiblement plan, concave ou convexe.

On cherche également à ce qu'au repos, la membrane 2 soit soumise à une contrainte résiduelle en compression suffisamment faible qui n'engendre ni fripement, ni flambage. De la même manière, au repos, la membrane 2 doit être soumise à une contrainte en tension suffisamment faible de manière à ce qu'elle réagisse efficacement à l'actionnement des moyens d'actionnement 5, ce qui ne serait pas le cas si elle était mise en tension de manière excessive. Un compromis est donc à trouver entre contrainte en tension et en compression.

La couche de renfort 2c doit être suffisamment rigide pour répercuter sur le fluide 4, emprisonné entre la membrane 2 et le support 1, la pression appliquée par les moyens d'actionnement 5 et donc générer les déplacements du fluide 4 recherchés. Quelques matériaux utilisables pour la couche de renfort sont listés ci-dessous. Il peut s'agir de matériaux métalliques tels que le titane, le nitrure de titane, l'aluminium dont l'épaisseur sera de l'ordre de la dizaine de nanomètres à quelques micromètres et dont le module d'Young est compris entre quelques dizaines de GPa à quelques centaines de GPa. Il peut s'agir de matériaux tels que l'oxyde de silicium, le nitrure de silicium dont l'épaisseur sera de l'ordre de la dizaine de nanomètres à quelques micromètres et dont le module d'Young est compris entre quelques dizaines de GPa à quelques centaines de GPa. Enfin il peut s'agir de matériaux organiques tels que les polymères photosensibles et en particulier les benzocyclobutènes (BCB) dont l'épaisseur sera de l'ordre de quelques dizaines de micromètres et dont le module d'Young est de quelques GPa.

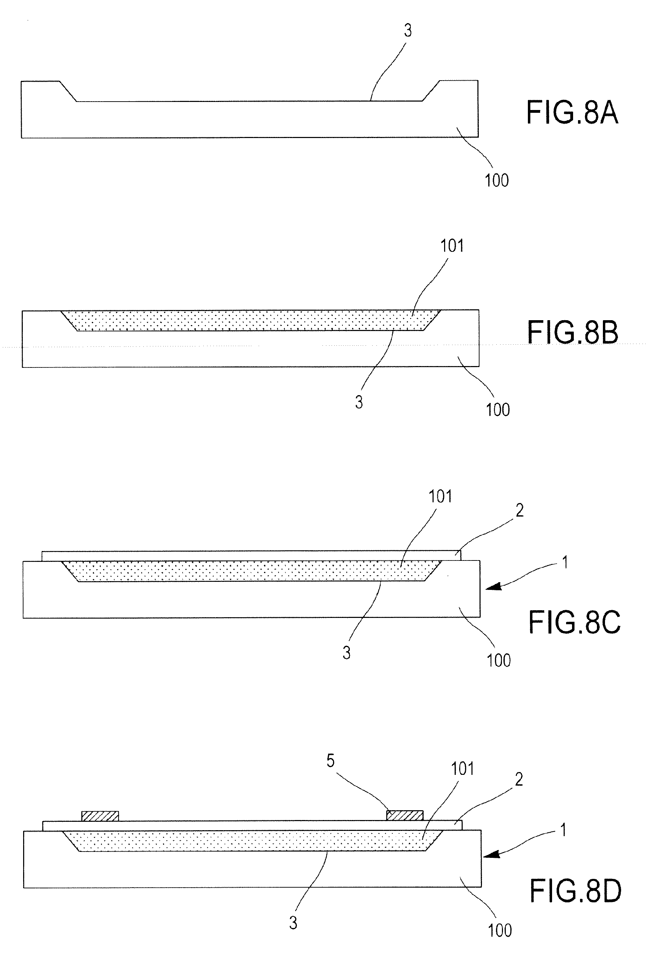

On va maintenant s'intéresser à un exemple de procédé de fabrication d'un dispositif optique à distance focale variable selon l'invention. On va utiliser une couche sacrificielle. On se reporte aux figures 8A à 8G.

On part d'un substrat 100 dans lequel une cuvette 3 a été gravée. Le substrat 100 peut être par exemple en verre (figure 8A). Il forme le support 1. On dépose dans la cuvette 3 un matériau sacrificiel 101 (figure 8B). Le matériau sacrificiel 101 peut être organique, une résine photosensible par exemple, ou un matériau minéral tel que de l'oxyde de silicium.

On forme la membrane 2 sur le matériau sacrificiel 101, de manière à ce qu'elle déborde sur le bord de la cuvette 3 et s'y ancre (figure 8C). On peut déposer un matériau choisi dans les matériaux énumérés plus haut pour la membrane 2. Le dépôt peut se faire à la tournette ou par dépôt chimique en phase vapeur.

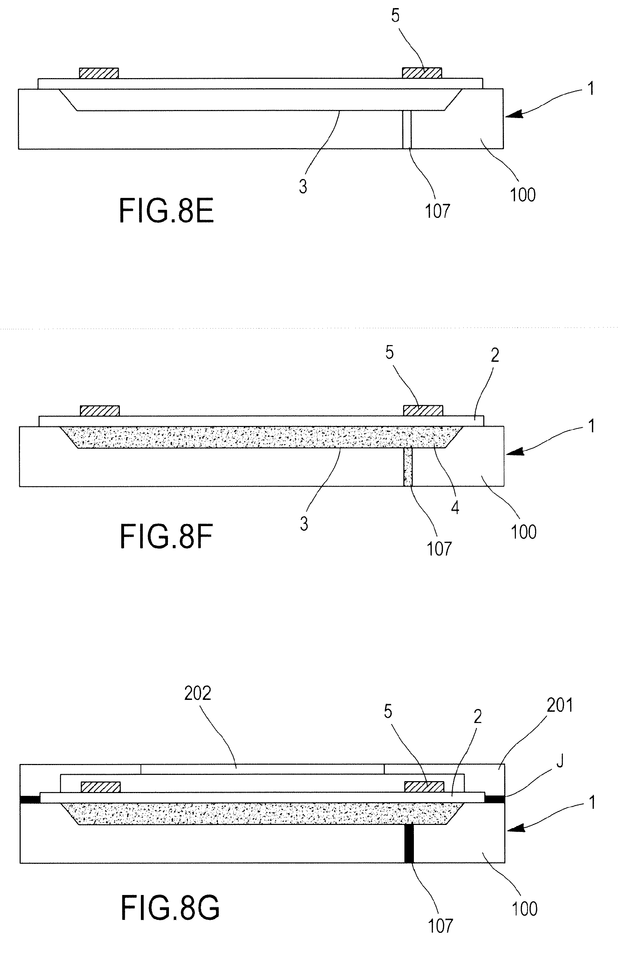

On forme ensuite les moyens d'actionnement 5 au niveau de la zone intermédiaire 2.2 ayant un contact ou non avec le support 1. On réalise d'abord une ou plusieurs électrodes sous-jacentes au matériau piézoélectriques à venir, puis on dépose la couronne continue circulaire en matériau piézoélectrique puis la ou les électrodes sus-jacentes, sachant qu'en final, il faut plusieurs paires d'électrodes. On n'a référencé ni la couronne, ni les électrodes pour ne pas surcharger les figures. Les techniques employées sont celles classiques utilisées dans les microsystèmes telles que les dépôts en couche mince, la lithographie et la gravure (figure 8D). On libère ensuite la membrane 2 en éliminant le matériau sacrificiel. Pour cela, on peut percer au moins un trou 107, hors du champ optique (zone centrale 2.1), dans le substrat 100 jusqu'à atteindre le matériau sacrificiel 101. Le trou 107 est traversant et débouche dans la cuvette 3 (figure 8E). L'élimination peut être chimique ou thermique ou par plasma d'oxygène. On remplit ensuite la cuvette 3 avec le fluide 4 (figure 8F). Le remplissage peut se faire en mettant la cuvette 3 en dépression pour favoriser la pénétration du fluide 4 et éviter la formation de bulles s'il s'agit d'un liquide. Enfin on rebouche le trou 107 pour que le fluide 4 ne puisse pas s'échapper (figure 8F). On peut utiliser un matériau organique. L'ordre des étapes n'est pas limitatif.

Les moyens d'actionnement 5 pourraient également être formés après la libération de la membrane 2 par exemple, avant le remplissage ou après. Il est également possible de les former sur la couche sacrificielle 101 avant de former la membrane 2, s'ils doivent se trouver en définitif du côté du fluide 4 emprisonné entre le support 1 et la membrane 2. Dans une telle configuration, la membrane 2 est sus-jacente aux moyens d'actionnement 5.

Si l'on désire que la membrane 2 au repos soit bombée, concave ou convexe, on donne une courbure appropriée à la face libre de la couche sacrificielle 101, puisqu'elle sert de moule à la membrane 2. Une autre solution pour obtenir une membrane 2 bombée serait de la faire flamber après l'avoir libérée. Le flambage peut être thermique. Les paramètres déterminants sont alors la différence de coefficients de dilatation thermique entre la membrane 2 et le substrat et la température de dépôt de la membrane 2.

Pour protéger la membrane 2, il est possible que le dispositif optique de l'invention soit réalisé par l'assemblage d'un support 1 et d'un capot 201 comme on l'a décrit à la figure 5L. Il n'est pas obligatoire que le capot 201 soit plein, sur la figure 8G, il évidé dans sa partie centrale, l'ouverture porte la référence 202. Un joint J de colle est utilisé pour assembler le support 1 et le capot 201.

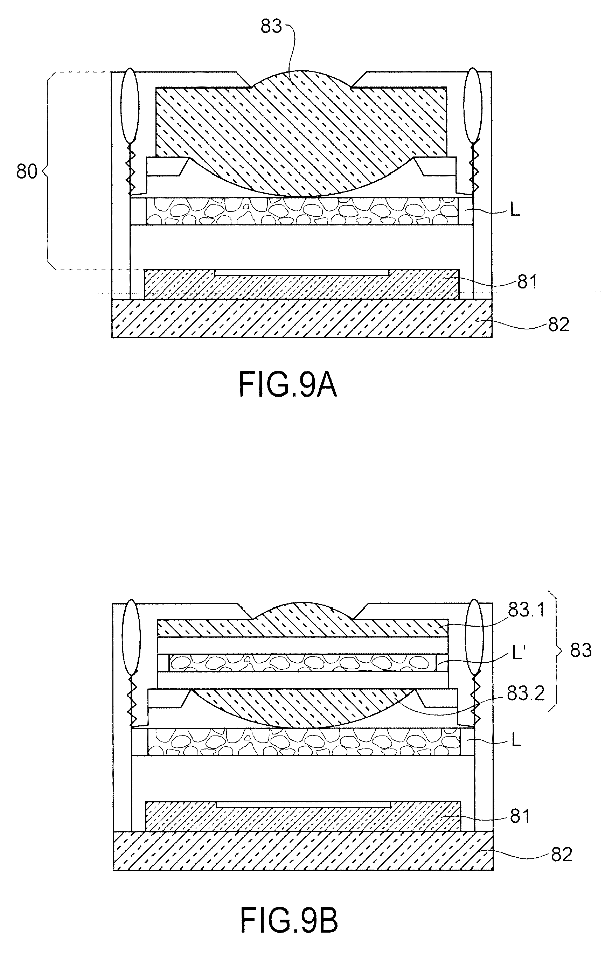

Un tel dispositif optique à distance focale variable peut être employé dans un dispositif de prise de vue notamment celui d'un appareil photo de téléphone portable. On se réfère à la figure 9A. Un tel dispositif de prise de vue comporte en cascade, un objectif 80 incluant au moins un dispositif optique à distance focale variable L selon l'invention de type lentille liquide, un capteur d'image 81 par exemple de type CCD ou CMOS porté par un substrat 82. Dans l'exemple décrit, l'objectif 80 comporte au moins une lentille 83 à distance focale fixe et une lentille liquide L selon l'invention. Par la suite cette lentille à distance focale fixe 83 sera appelée bloc optique conventionnel. La lentille liquide L se trouve accolée au bloc optique conventionnel 83 du côté du capteur d'image 81. En variante le bloc optique conventionnel 83 peut se trouver entre la lentille liquide L et le capteur d'image 81. Le bloc optique conventionnel 83 est statique. Comme on l'a vu précédemment, de par son procédé de fabrication, la lentille liquide L peut être assimilée à un MOEMS (microsystème optoélectromécanique). La lentille liquide L à focale variable est placée à une certaine distance, qui dépend des caractéristiques de l'objectif 80, du capteur d'image 81, mais si cette distance est petite, la lentille liquide L et le capteur d'image 81 ne pourront faire qu'un seul composant en les intégrant soit en technologie AIC (abréviation anglo-saxonne de Above Integrated Circuit pour au-dessus du circuit inégré), soit en technologie WLCSP (abréviation anglo-saxonne de Wafer Level Chip Scale Package soit sur tranche à l'échelle de la puce). La distance focale de la lentille liquide L est adaptée en optimisant la pression du liquide au repos, mais aussi la courbure de la membrane 2 au repos et l'indice de réfraction du liquide.

Si le dispositif de prise de vue inclut également la fonction zoom comme sur la figure 15B, on utilisera, un bloc optique 83 avec au moins deux lentilles à distance focale fixe 83.1 83.2 et deux lentilles liquides L et L' dont l'une se trouve entre les deux lentilles 83.1, 83.2 du bloc optique 83 et l'autre accolée au bloc optique 83 du côté du capteur d'image 81 comme sur la figure 9B. Sur ces figures 9A, 9B, les dispositifs optiques selon l'invention référencés L et L' sont représentés très schématiquement, on ne voit pas leurs moyens d'actionnement 5.

Avec un dispositif optique selon l'invention ayant un encombrement donné, on peut maximiser la surface des moyens d'actionnement 5 en utilisant une unique couronne continue en matériau piézoélectrique qui accueille un ou plusieurs actionneurs piézoélectriques. L'énergie apportée par les moyens d'actionnement peut être maximisée ce qui permet soit d'améliorer les déplacements du fluide et donc d'améliorer les performances du dispositif optique à tension d'alimentation constante, soit de minimiser la tension d'alimentation à performances optiques équivalentes.

En ancrant les moyens d'actionnement seulement à la membrane dans la zone intermédiaire, on peut réduire l'encombrement du dispositif par rapport aux configurations dans lesquelles les moyens d'actionnement sont ancrés sur le support.

Le fait de prévoir des moyens de compensation d'une variation de la distance focale due à une variation de température permet de maintenir constante la distance focale du dispositif quelle que soit la température prise dans une plage donnée.

Des simulations ont été réalisées pour comparer un dispositif optique selon l'invention à un dispositif optique dans lequel les moyens d'actionnement comportent plusieurs actionneurs piézoélectriques en forme de poutres radiales comme dans la demande de brevet français FR 2 919 073. Ces simulations ont été réalisées en sollicitant la structure sans la présence de liquide.

La figure 10A montre un modèle en deux dimensions axisymétriques de la membrane équipée des moyens d'actionnement 5 en couronne continue. La membrane formée d'une couche homogène en parylène a un rayon de 2 millimètres et une épaisseur de 1 micromètre. La couronne continue a une largeur de 500 micromètres et une épaisseur d'un micromètre. Elle est réalisée en PZT. La couronne continue est ancrée au support dans la zone d'ancrage.

La figure 10B est un modèle en trois dimensions cyclique de la membrane équipée d'une poutre 50 à l'échelle micrométrique. La membrane formée d'une couche homogène en parylène a un rayon de 2 millimètres et une épaisseur de 1 micromètre. La poutre a une longueur de 500 micromètres, une largeur de 100 micromètres et une épaisseur de 1 micromètre. Elle est réalisée en PZT. La poutre est ancrée au support dans la zone d'ancrage.

Le graphique de la figure 10C montre l'évolution de la flèche de la membrane dans la zone centrale en fonction de la tension de polarisation appliquée aux moyens d'actionnement. La courbe référencée A correspond à la couronne continue et la courbe référencée B correspond à la poutre. On peut distinguer deux régimes R1, R2 intéressants. Les deux courbes A, B sont sécantes, le point d'intersection est noté I. Dans le premier régime R1 qui correspond à des tensions de polarisation inférieures à environ 0,32 V, à gauche du point d'intersection I, la poutre donne les meilleures flèches. L'anneau continu est victime d'un effet de rigidité qui est à l'origine d'une perte d'efficacité énergétique. La différence entre les flèches est même de l'ordre de 25% pour la tension de polarisation la plus faible (0,1 V). Dans le second régime R2, pour des tensions supérieures à environ 0,32V, à droite du point d'intersection I, la couronne continue donne les meilleurs résultats. Elle bénéficie d'un effet de surface qui entraîne une meilleure efficacité énergétique. La différence entre les flèches est même de l'ordre de 33% pour la tension de polarisation la plus élevée (1 V).

Bien que plusieurs modes de réalisation de la présente invention aient été décrits de façon détaillée, on comprendra que différents changements et modifications puissent être apportés sans sortir du cadre de l'invention et notamment bien d'autres procédés peuvent être utilisés pour réaliser la membrane et les moyens d'actionnement.

## Revendications

1. Dispositif optique à membrane (2) déformable comportant une zone d'ancrage (2.3) sur un support (1) contribuant à emprisonner une quantité de fluide liquide ou gazeux, une zone centrale (2.1) apte à se déformer de manière réversible depuis une position de repos, des moyens d'actionnement pour déplacer le fluide (4) sollicitant la membrane (2) dans une zone intermédiaire entre la zone d'ancrage (2.3) et la zone centrale (2.1), **caractérisé en ce que** les moyens d'actionnement comportent une couronne continue en matériau piézoélectrique accueillant un ou plusieurs actionneurs piézoélectriques (5.1) formés chacun d'une paire d'électrodes prenant en sandwich la couronne continue (C), cette couronne continue étant montée autour de la zone centrale (2.1) sans empiéter sur elle, les moyens d'actionnement (5) étant ancrés à la membrane (2) au moins dans la zone intermédiaire (2.2), les moyens d'actionnement (5) et la membrane (2) à laquelle ils sont ancrés, formant au moins un bimorphe piézoélectrique (B), les moyens d'actionnement (5) étant intégrés à la membrane (2) au moins partiellement et se contractant ou s'étendant radialement lors d'un actionnement de manière à engendrer un déplacement dudit fluide (4) depuis la zone intermédiaire (2.2) vers la zone centrale (2.1) de la membrane (2) ou vice versa, visant à déformer et à ajuster la déformation de la zone centrale (2.1) par rapport à sa position de repos.

2. Dispositif optique selon la revendication 1, dans lequel au moins une électrode (20a) d'une paire d'électrodes est commune à deux actionneurs piézoélectriques ou à plus de deux actionneurs piézoélectriques.

3. Dispositif optique selon l'une des revendications 1 ou 2, dans lequel les moyens d'actionnement (5) sont aussi ancrés sur la zone d'ancrage (2.3) de la membrane (2) et éventuellement sur le support (1) directement.

4. Dispositif optique selon l'une des revendications précédentes, dans lequel, la membrane (2) comporte un empilement de couches (2a, 2b) au moins au niveau de la zone intermédiaire (2.2), parmi lesquelles une couche de renfort (2c) plus rigide et une couche moins rigide (2b), la couche plus rigide (2a) faisant partie du bimorphe piézoélectrique (B).

5. Dispositif optique selon l'une des revendications précédentes, dans lequel la membrane (2) comporte une couche continue (2b) qui s'étend au niveau de la zone centrale (2.1), de la zone intermédiaire (2.2) et de la zone d'ancrage (2.3).

6. Dispositif optique selon l'une des revendications 1 à 5, comportant en outre des moyens d'actionnement auxiliaires (5') ancrés à la membrane (2) comportant une couronne discontinue (Caux) en matériau piézoélectrique accueillant un ou plusieurs actionneurs piézoélectriques (5.2), la couronne discontinue (Caux) étant montée concentriquement avec la couronne continue (C), les moyens d'actionnement auxiliaires (5.2) et la membrane (2) à laquelle ils sont ancrés formant au moins un bimorphe piézoélectrique.

7. Dispositif optique selon l'une des revendications précédentes, comportant des moyens de compensation (95) d'une variation de la distance focale du dispositif optique en fonction de la température.

8. Dispositif optique selon la revendication 7, dans lequel les moyens de compensation (95) sont confondus avec au moins un des actionneurs piézoélectriques (5.1) accueillis sur la couronne continue (C).

9. Dispositif optique selon la revendication 8, dans lequel les moyens de compensation (95) comportent un ou plusieurs éléments bimorphes thermiques (95.1) agencés en couronne continue soit ancrés à la membrane (2) au niveau de la zone d'ancrage (2.3) en débordant sur la zone intermédiaire (2.2), soit fixés au support (1) à l'opposé de la membrane (2) par rapport audit fluide (4).

10. Dispositif optique selon l'une des revendications précédentes, dans lequel les actionneurs piézoélectriques (5.1) des moyens d'actionnement (5) sont actionnables séparément les uns des autres ou bien tous ensemble simultanément ou bien encore ils sont actionnables simultanément par groupes.

11. Dispositif optique selon l'une des revendications précédentes, comportant un ou plusieurs actionneurs piézoélectriques (70) agencés sur une couronne continue (C') en matériau piézoélectrique, ancrés à la membrane (2) dans la zone intermédiaire (2.2) et éventuellement dans la zone d'ancrage (2.3), aptes à fonctionner passivement par effet piézoélectrique direct et dédiés à une surveillance d'une déformation de la membrane (2).

12. Dispositif optique selon l'une des revendications précédentes, comportant en outre un capot (201) de protection fixé sur le support (1).

13. Dispositif optique selon la revendication 12, dans lequel le capot (201) est muni d'une ouverture (202) au niveau de la zone centrale (2.1) ou est étanche et emprisonne un autre fluide (4').

14. Dispositif optique selon l'une des revendications précédentes, **caractérisé en ce que** c'est une lentille ou un miroir.

15. Dispositif de prise de vue, **caractérisé en ce qu'**il comporte au moins un dispositif optique (L, L') selon l'une des revendications précédentes.
